# EUROPÄISCHE PATENTSCHRIFT

(11) **EP 1 261 882 B1**
(45) Veröffentlichungstag und Bekanntmachung des Hinweises auf die Patenterteilung: **10.11.2004**
(21) Anmeldenummer: 01905477.4
(22) Anmeldetag: 15.02.2001
(51) Int. Cl.: G01R 31/28, H03K 17/95

(54) **EINRICHTUNG ZUR ÜBERWACHUNG UND PROGNOSE DER AUSFALLSWAHRSCHEINLICHKEIT VON INDUKTIVEN NÄHERUNGSSENSOREN**
DEVICE FOR MONITORING AND FORECASTING THE PROBABILITY OF INDUCTIVE PROXIMITY SENSOR FAILURE
DISPOSITIF DESTINE A SURVEILLER ET A PRONOSTIQUER LA PROBABILITE DE PANNE DE DETECTEURS INDUCTIFS DE PROXIMITE

(30) Priorität: 23.02.2000 AT 2812000
(43) Veröffentlichungstag der Anmeldung: 04.12.2002
(73) Patentinhaber: VAE EISENBAHNSYSTEME GMBH, 8740 Zeltweg (AT); VAE GmbH, 1010 Wien (AT)
(72) Erfinder: FRAUSCHER, Josef, A-4774 St. Marienkirchen (AT)
(74) Vertreter: Haffner, Thomas M., Dr.
(86) Internationale Anmeldenummer: PCT/AT2001/000037
(87) Internationale Veröffentlichungsnummer: WO 2001/063309

(56) Entgegenhaltungen:
- WO-A-97/33784
- DE-A- 3 600 896
- DE-C- 3 342 710

## Beschreibung

Die Erfindung bezieht sich auf eine Einrichtung zur Überwachung und Prognose der Ausfallswahrscheinlichkeit von induktiven Näherungssensoren zur Überwachung der Position von beweglichen Weichen- oder Schienenteilen, bei welcher der Näherungssensor wenigstens eine von einem Oszillator gespeiste Spule aufweist und der durch veränderliche Bedämpfung fließende Sensorstrom gemessen und einer Auswerteschaltung zugeführt wird.

Für die Überwachung der An- bzw. Ablage von Zungen an Backenschienen können beispielsweise induktive Sensoren verwendet werden. Um die Anlage der Zunge an einer Backenschiene zu erfassen, kann der induktive Sensor im Steg der Backenschiene eingebaut sein, wobei für die Ablage der Zunge entweder der unbedämpfte Zustand dieses Sensors oder ein weiterer spezifisch ausgestalteter induktiver Sensor eingesetzt werden kann. Derartige Sensoren, liefern je nach Bedämpfung einen bestimmten Strom und es kann die Stromaufnahme des Sensors überwacht werden und auf diese Weise eine Abstandsinformation gewonnen werden. Aus der AT 399 851 B ist ein Verfahren zum überwachen des Zustandes von Schienenweichen bekannt geworden, bei welchem zusätzlich während des Befahrens der Weiche gewonnene Signale ausgewertet werden und jeweils der kleinste Wert des Abstandes gespeichert wird, wobei die Änderung des gemessenen kleinsten Wertes sowie wenigstens ein erster Grenzwert für den kleinsten Abstand miteinander verglichen werden. Auf diese Weise sollte ein vorzeitiger Verschleiß. im Bereich der Zungenschiene einer Weiche erkannt werden. In der WO 97/33784 wurde vorgeschlagen den Sensor als kontinuierlichen Abstandsensor auszubilden und zwei gesonderte Auswertungen vorzunehmen, wobei eine Auswertung den jeweiligen Abstand und die zweite Auswertung eine Funktionskontrolle des Sensors bieten soll, wobei vorgegebene Toleranzfenster der Kennlinien als maßgebend erachtet wurden.

Prinzipiell sind als kontinuierliche Abstandsensoren ausgebildete Sensoren zumeist als induktive Sensoren ausgebildet, wobei eine Spule mit freischwingendem Oszillator eingesetzt wird, dessen Schwingungsamplitude sich bei Annäherung von ferromagnetischem bzw. elektrisch leitendem Material ändert, wodurch eine entsprechende Änderung der Stromaufnahme gemessen werden kann. Aus der gemessenen Stromaufnahme kann in einer Auswerteschaltung die entsprechende Abstandsinformation gewonnen werden.

Zur Überwachung der korrekten Funktion induktiver Näherungssensoren wurde in der DE-C-31 50 212 bereits vorgeschlagen Prüfsignale einzusetzen. Mittels derartiger Prüfsignale soll eine elektrische Dämpfung oder Entdämpfung erreicht werden, wobei eine Auswertung der Änderung des Signales bei angelegtem Prüfsignal und ohne Prüfsignal eine Beurteilung der Verfügbarkeit des Näherungssensors ergeben sollte. Mit derartigen Schaltungsanordnungen läßt sich prinzipiell erkennen, ob ein Sensor korrekt angeschlossen, und insbesondere ob ein Sensor defekt ist, da in solchen Fällen das Anlegen eines Prüfsignales keine auswertbaren Veränderungen erkennen läßt.

In der DE 36 00 896 A1 wird eine Einrichtung zur Überwachung eines Näherungsschalters für eine automatische Rottenwarnanlage beschrieben. Die Überwachung des Näherungsschalters soll die Erkennung eines etwaigen Abfahrens des Näherungsschalters von der Schiene ermöglichen und wird dadurch erreicht, dass den Ansprechspulen des Näherungsschalters mindestens eine mit einem Widerstand beschaltete Hilfswicklung zugeordnet ist, welche mit einem überwachungstakt beaufschlagt und mit dem Widerstand derart abgeglichen ist, dass bei vorschriftsmäßiger Anbringung des Näherungsschalters dessen Ansprechgrenze geringfügig überschritten ist. Dies bedeutet, dass die ferngesteuerte Hilfswicklung mit ihrem Widerstand so abgeglichen wird, dass dem Schwingkreis des Näherungsschalters die gleiche Energie entzogen wird wie durch das Schaltblech von herkömmlich ausgebildeten Näherungsschaltern, sodass der gleiche Schaltstrom fließt.

Aus der DE 33 42 710 C1 ist ebenfalls ein Näherungsschalter bekannt, welcher zur Überwachung seiner Funktion und Funktionsbereitschaft ausgebildet ist. Der Näherungsschalter der DE 33 42 710 C1 ist als Zweileiterschaltung ausgebildet, wobei für die Funktionsprüfung und Funktionsüberwachung keine Erhöhung der Versorgungsspannung nötig ist, indem die Funktion des Näherungsschalters bei funktionsmäßig entdämpftem Oszillator durch eine elektrische Bedämpfung und bei funktionsmäßig bedämpftem Oszillator durch eine elektrische Entdämpfung geprüft wird.

Die Erfindung zielt nun darauf ab, eine Einrichtung zur Überwachung und Prognose der Ausfallswahrscheinlichkeit von induktiven Näherungssensoren zur Überwachung der Position von beweglichen Weichen- oder Schienenteilen zu schaffen, bei welcher das Prinzip der bekannten Testbedämpfung verwendet wird, wobei aber nun eine Selbsttesteinrichtung für induktive Abstandsensoren für das gesamte Signalverhalten geschaffen werden soll, um aus Änderungen eines möglichen Kennlinienverlaufes eine Ausfallprognose für den Sensor zu erstellen. Mögliche Ursachen für eine erhöhte Ausfallwahrscheinlichkeit sind insbesondere eine Verringerung des Isolationswiderstandes zwischen den Leitern durch Eindringen von Wasser und damit eine Ausbildung von parasitären Widerständen, mechanische Schäden oder Bauteilschäden in der Schaltung sowie Fehler in der Sensorelektronik, welche zu einer Veränderung der Abstand-Strom-Kennlinie führen, wodurch falsche Abstandsinformationen ermittelt werden. Die erfindungsgemäße Einrichtung soll rechtzeitig derartige Veränderungen aufzeigen, sodaß die Wartung bzw. der Austausch eines Sensors bereits lange vor seinem eigentlichen Ausfall erfolgen kann. Zur Lösung dieser Aufgabe besteht die erfindungsgemäße Einrichtung im wesentlichen darin, daß Kennlinien des Sensors für den Verlauf der Sensorströme in Abhängigkeit vom Abstand der beweglichen weichenoder Schienenteile, d.h. der mechanischen Bedämpfung, in elektrisch nicht zusätzlich bedämpftem Zustand und in elektrisch zusätzlich bedämpftem Zustand gespeichert sind und daß die einem mechanischen Bedämpfungszustand entsprechenden, sowie jeweils die entsprechenden zusätzlich elektrisch bedämpften Meßströme zyklisch abgetastet werden und die jeweiligen Meßströme bzw. Meßwertpaare einer Vergleichs- und Auswerteschaltung zugeführt sind, in welcher die sich aufgrund der Kennlinien ergebenden Differenzen mit den gemessenen Differenzen verglichen werden. Induktive Sensoren werden üblicherweise nach dem Einjustieren abgenommen, wobei eine Kennlinie des Sensors für die verschiedenen Positionen einer Zunge relativ zu einer Backenschiene aufgenommen wird. Dadurch, daß nun diese Kennlinie und eine weitere Kennlinie aufgenommen wird, bei welcher der Sensor zusätzlich elektrisch bedämpft wurde, und diese beiden Kennlinien gespeichert werden, ist es in der Folge möglich, unabhängig von der jeweiligen Position der Zunge relativ zur- Backenschiene, Voraussagen für die Ausfallwahrscheinlichkeit zu treffen. Im Normalfall weist ein defekter Sensor im unbedämpften Zustand klar unterscheidbares Signal zum intakten Sensor aus. In maximal mechanisch unbedämpftem Zustand eines derartigen Sensors hat sich jedoch gezeigt, daß sich die Signale eines defekten Sensors nicht wesentlich von den Signalen eines intakten Sensors unterscheiden lassen. Erst durch die zusätzliche Überprüfung der Meßwerte für eine elektrisch bedämpfte Schaltungsanordnung können Unterschiede zwischen intakten Sensoren und defekten Sensoren deutlich erkannt werden, wenn zu diesem Zweck jeweils ein Vergleich mit den ursprünglichen Kennlinien des intakten Sensors vorgenommen wird. Zu diesem Zweck wird erfindungsgemäß vorgeschlagen, daß die einem mechanischen Bedämpfungszustand entsprechenden sowie die lisch abgetastet werden und die jeweiligen Meßströme bzw. Meßwertpaare einer Vergleichs- und Auswerteschaltung zugeführt sind. In einer derartigen Vergleichs- und Auswerteschaltung kann in der Folge anhand der gespeicherten Kennlinien eine Auswertung vorgenommen werden, wobei Differenzen gegenüber den sich aus den Kennlinien eines intakten Sensors ergebenden Differenzen eine entsprechende Prognose der Ausfallwahrscheinlichkeit ermöglichen.

In besonders vorteilhafter Weise ist die Ausbildung hierbei so getroffen, daß die Signale der Meßwertpaare für wenigstens zwei unterschiedliche mechanische Bedämpfungen der Auswerteschaltung zugeführt sind. Über den gesamten Signalverlauf konnte gezeigt werden, daß die Differenz der Meßwerte für einen intakten Sensor und einen defekten Sensor in elektrisch unbedämpftem Zustand von der tatsächlichen Position und damit vom Abstand des Meßobjektes abhängt. Insbesondere konnte gezeigt werden, daß diese Differenz bei maximaler mechanischer Bedämpfung größer ist als bei minimaler mechanischer Bedämpfung, d.h. bei abliegender Zunge. Aus diesem Verhalten der Kennlinie eines intakten und eines schadhaften Sensors ohne elektrische Bedämpfung ergibt sich unmittelbar, daß über einen großen Teilbereich der Kennlinie exakte Aussagen über das Ausmaß eines Defektes nicht getroffen werden können, da die Differenz zwischen den Signalen eines intakten und eines defekten Sensors nicht signifikant ist. Signifikante Änderungen ergeben sich erst in der maximal mechanisch bedämpften Position, wobei allerdings hier, ohne Zuhilfenahme der Kennlinie eines elektrisch bedämpften Sensors, falsche Abstandswerte gewonnen werden können, da insbesondere ein zu geringer Meßstrom bereits in einem Abstand von der Anlage eine Anlageposition signalisieren würde und dem Meßstrom entspricht, welcher bei einem intakten Sensor der Anlage einer zunge an eine Backenschiene entspricht. Erst durch Vergleich mit den Meßwerten und Kennlinien eines zusätzlich elektrisch bedämpften Sensors werden derartige Differenzen auswertbar und erlauben die entsprechenden Rückschlüsse auf die Fehler und Ausfallwahrscheinlichkeit.

In besonders einfacher Weise kann die elektrische Bedämpfung durch eine Anhebung der Versorgungsspannung erfolgen. Diese empfiehlt sich insbesondere für den Einsatz der sogenannten Zweidrahttechnik, bei welcher aufgrund der Verringerung der Anzahl der elektrischen Leitungen statistisch eine Verringerung der Fehlerwahrscheinlichkeit eintritt. Die Schaltung für die Ermittlung des zusätzlich elektrisch bedämpften Signales kann mit Vorteil so ausgebildet sein, daß die elektrische Bedämpfung über einen Abgriff der Sensorspule erfolgt, wobei mit Vorteil ein die elektrische Bedämpfung über einen Widerstand am Abgriff der Sensorspule steuernder Transistor vorgesehen ist, dessen Basis über eine Z-Diode mit der Spannungsquelle verbunden ist. Auf diese Weise gelingt es durch einfaches Anheben der Versorgungsspannung unmittelbar die elektrische Bedämpfung zuzuschalten- und durch Absenken der Versorgungsspannung wiederum lediglich den Meßwert für eine ausschließlich mechanische Bedämpfung zu gewinnen. Insgesamt wird mit Vorteil so vorgegangen, daß wenigstens eine Auswertung der Differenz der Meßwertpaare in mechanisch unbedämpfter Lage erfolgt, wobei die Auswertung so erfolgen kann, daß jeweils ein einem bestimmten Abstand entsprechender Konstantstrom gemessen wird.

Durch das zyklische Zuschalten eines Miderstandes zum Schwingkreis erfolgt somit eine in der Größe definierte Bedämpfung des Schwingkreises und durch die Zuschaltung durch Erhöhen der Versorgungsspannung kann mit lediglich zwei Drähten das Auslangen gefunden werden. Bei der Bedämpfung durch Sensorgehäuse, Montage und Meßobjekten handelt es sich, funktionell gesehen, um Wirbelstromverluste, welche als Wirkverluste zu einer Verringerung der Schwingungsamplitude der Oszillators und damit zu einer Verringerung der Stromaufnahme führen.

Die Wirkung eines Widerstandes parallel zum Schwingkreis gleicht der Wirkung von Wirbelstromverlusten und es kann auf diese Weise nahezu jeder Sensorfehler, der zu einer Veränderung des Signalverhaltens führt, durch eine zyklische Testbedämpfung und eine entsprechende Auswertung des Sensorstromes ermittelt werden.

Durch Vergleich mit den entsprechenden Kennlinien läßt sich auch eine Prognose hinsichtlich des Verhaltens des Sensors bei einem Bedämpfen durch das Meßobjekt, d.h. bei Bedämpfung durch die sich von der Ablage in Anlage bewegende Zunge erzielen. Wenn eine derartige Prognose nicht den erwarteten Sensorstrom ergibt, kann auf einen Sensorfehler geschlossen werden.

Die Erfindung wird nachfolgend anhand der Zeichnungen näher erläutert. In dieser zeigen Fig. 1 eine schematische Meßanordnung eines induktiven Sensors, Fig. 2 ein detailliertes Schaltbild, Fig. 3 den Kennlinienverlauf für die Abhängigkeit des Sensorstromes vom Abstand des Meßobjektes zur Sensormeßfläche bei unterschiedlichen Zuständen des Sensors in elektrisch unbedämpftem und elektrisch bedämpftem Zustand sowie Fig. 4 das Signalverhalten bei zyklischer Beschaltung mit der elektrischen Bedämpfung.

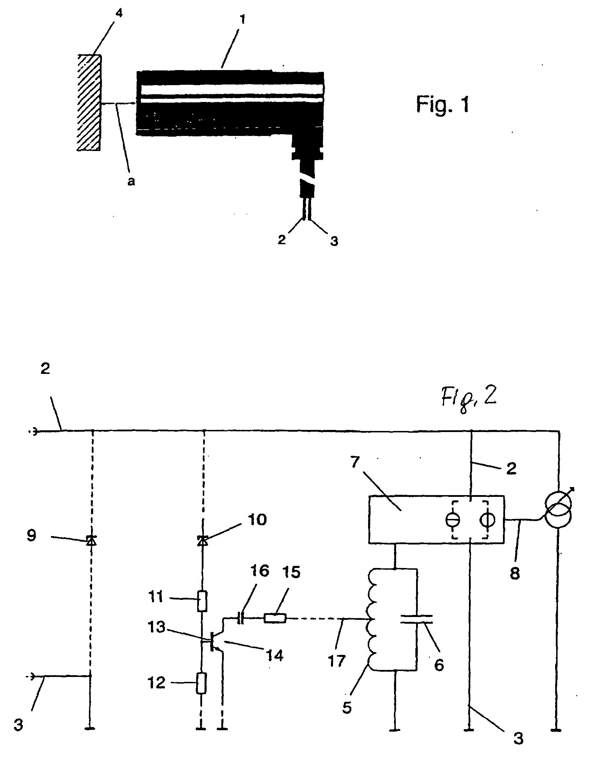

In Fig. 1 ist ein induktiver Näherungssenor 1 dargestellt, welcher zwei elektrische Zuleitungen 2 und 3 aufweist. Das Meßobjekt, beispielsweise eine Weichenzunge, welches aus ferromagnetischem bzw. elektrisch leitendem Material bestehen muß, ist schematisch mit 4 angedeutet. Mittels des Sensors 1 kann aufgrund der gemessenen Ströme auf den Abstand a zwischen dem Meßobjekt und der Sensoroberfläche geschlossen werden.

Eine prinzipielle Schaltungsanordnung ist in Fig. 2 dargestellt.

In Fig. 2 ist mit 5 eine Schwingkreisspule bezeichnet, wobei das für den Schwingkreis charakteristische LC-Glied einen Kondensator 6 aufweist. Eine Annäherung eines Meßobjektes an die Spule 5 führt zu einer mechanischen Bedämpfung, wobei der Oszillator schematisch mit 7 bezeichnet ist und je nach Schwingungsamplitude einen entsprechenden Konstantstrom liefert, welcher über die Signalleitung 8 abgegeben wird.

Im Meßbetrieb dieses Sensors in Zweidrahtschaltung wird der spannungsquelle gespeist und zeigt daher bei Veränderung der Versorgungsspannung keine wesentlichen Veränderungen. Die Versorgungsspannung wird über die Leitung 2 und 3 zugeführt, wobei eine erste Zenerdiode 9 vorgesehen ist, mit welcher Spannungsspitzen eliminiert werden sollen, welche zu Störungen der Schaltungsanordnung führen könnten. Diese erste Zenerdiode 9 ist auf eine höhere Durchlaßspannung ausgelegt als die zweite in Fig. 2 dargestellte Zehnerdiode 10.

Durch Anheben der Versorgungsspannung von typisch 12 bis 18. V auf beispielsweise 22 V kann nun bei entsprechender Auslegung der Zenerdiode 10 Strom über die Widerstände 11 und 12, welche einen Spannungsteiler bilden, fließen und auf diese Weise die Basis 13 des Transistors 14 leitfähig gemacht werden, sodaß nun über den Widerstand 15, den Kondensator 16 sowie den Kollektor und den Emitter des Transistors 14 Strom fließen kann. Da dieser Widerstand 15 über die Leitung 17 an einem Abgriff der Spule 5 angeschlossen ist, erfolgt in diesem Falle eine elektrische Bedämfpung des Schwingkreises, wodurch die gemessene Amplitude verändert wird und weitere Signale über die Leitung 8 gewonnen werden können.

Die Konstantstromquelle bzw. die Konstantspannungsquelle steuert einen Verstärker an, der das Sensorsignal in Form eines eingeprägten Stromsignales auf der Versorgungsleitung abgibt. Auch dieser Verstärker weist keine Spannungsabhängigkeit auf. Dem Schwingkreis wird über die Anzapfung einer Sensorspule bei zugeschalteter elektrischer Bedämpfung Energie entzogen, wobei ein solcher Energieverlust, welcher physikalisch einem Verlust entspricht, der durch Wirbelstrom- und Ummagnetisierungsverluste an der Sensorspule verursacht werden kann, zu einer Veränderung der Stromwerte vor und nach der definierten Bedämpfung führt, welcher jeweils mit den entsprechenden Sollkennlinien zwischen den beiden Punkten verglichen werden kann.

Gesteuerte Spannungsveränderungen erlauben gleichzeitig einen begrenzten Test der Sensorschaltung, sowie auch des Kabelweges.

Eine Veränderung des Stromsignales nach dem Anheben oder Absenken der Versorgungsspannung würde bedeuten, daß entweder ein Defekt am Kabelweg oder einem Schaltungsteil des Sensors vorliegt. Wenn der Sensor zyklisch geprüft wird, kann die Anzahl der für unbemerkte Ausfälle des Sensors verantwortlichen Bauteile deutlich reduziert werden. Gesteuert von der Zenerdiode 10 wird somit der Transistor 14 als Schalter eingesetzt, welcher bei einer definierten Anhebung der Versorgungsspannu.ng Energie aus dem Schwingkreis über den Widerstand ableitet. Ein derartiger Schaltvorgang für das zyklische Abtasten der elektrisch bedämpften Meßwerte kann durch kurzzeitiges Erhöhen der Sensorversorgungsspannung veranlaßt werden. Unerwünschte parasitäre Widerstände würden bei einer Anhebung der Versorgungsspannung zu einer Stromerhöhung führen, wobei durch die Schaltungsanordnung auch derartige Fehler erkennbar werden.

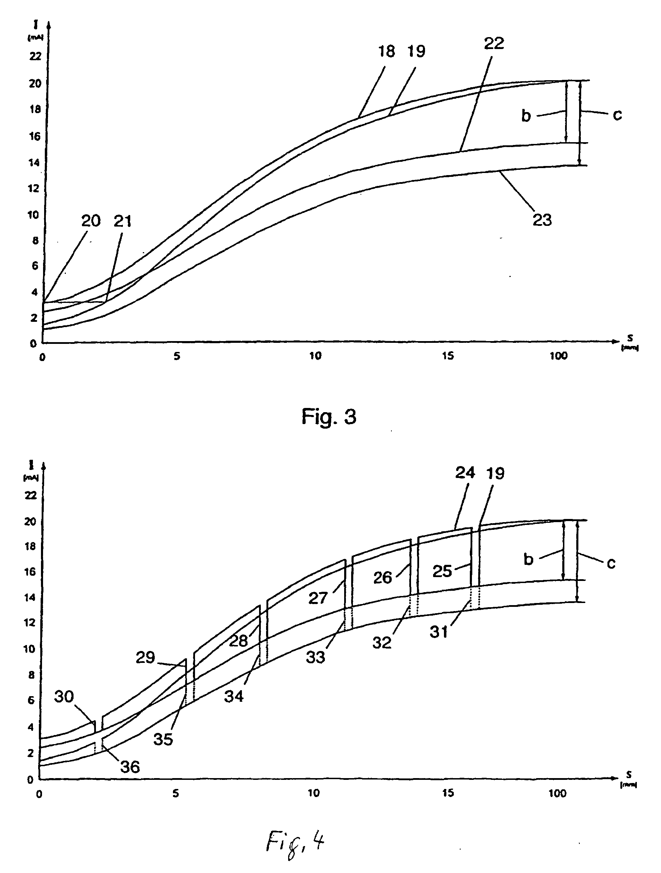

Die charakteristischen Kennlinienverläufe sind nun in den Fig. 3 und Fig. 4 dargestellt.

In Fig. 3 ist hiebei eine erste Kennlinie 18 ersichtlich, welche den Verlauf der Stromaufnahme in Abhängigkeit von der mechanischen Bedämpfung wiedergibt. Bei einem schadhaften bzw. schadhaft werdenden Sensor sinkt dieser Strommeßwert entsprechend der Kurve 19 ab, wobei gleichzeitig ersichtlich ist, daß die Veränderung der Meßwerte bei maximalem Abstand, d.h. mechanisch unbedämpftem Zustand des Sensors, insignifikant gering wird und erst mit Verringerung des Abstandes und damit mit Zunahme der mechanischen Bedämpfung deutlich meßbar wird. Ein schadhafter Sensor, dessen Kennlinienverlauf beispielsweise der Kurve 19 entspricht, würde aber dann, wenn nicht gleichzeitig erkannt wird, daß der Sensor schadhaft ist, zu falschen Abstandswerten führen, da der minimale Strom bei Anlage einer Zunge im Punkt 20 bei einem intakten Sensor auf der Kennlinie des defekten Sensors bereits in Punkt 21 erreicht wird, welcher damit einen zu großen Abstand in der entsprechenden Auswertung ergeben würde.

Der Kurvenzug 22 entspricht nun einem intakten Sensor bei gleichzeitiger zusätzlicher elektrischer Bedämpfung. Es hat sich nun gezeigt, daß sich bei einem defekten Sensor hier bei zugeschalteter elektrischer Bedämpfung entsprechend dem Kurvenverlauf der Kurve 23 auch in Ablage der Zunge bereits signifikante Differenzen ergeben, welche auf einen schadhaften Sensor schließen lassen. Die Differenz, wie sie für die Ablage der Zunge zwischen den Zuständen ohne und mit elektrischer Bedämpfung gemessen wird, entspricht hiebei der Differenz der Meßströme b, wohingegen diese Differenz im Falle eines defekten Sensors wesentlich größer wird und c entspricht.

Wenn nun, wie in Fig. 4 dargestellt ist, zyklisch die elektrische Bedämpfung zugeschaltet wird, ergibt sich für einen intakten Sensor jeweils ein Signalverlauf, welcher dem Kurvenzug 24 in Fig. 4 entspricht, wobei deutlich die jeweils bei Schalten des Transistors registrierte Verringerung der Stromaufnahme ersichtlich ist. Diese Verringerung wird jeweils durch die Teilbereiche.25, 26, 27, 28, 29 und 30 des Kurvenverlaufes eines intakten Sensors angedeutet, wobei sich gleichzeitig ergibt, daß diese Differenz für unterschiedliche mechanische Bedämpfungen des Sensors verschieden ist.

Wenn nun ein defekter Sensor vorliegt, dann vergrößert sich die Differenz an den angegebenen Stellen des Kurvenverlaufes, wobei die zusätzlich gemessene Stromdifferenz durch den Kurvenzug an den Stellen 31, 32, 33, 34, 35 und 36 angedeutet ist. In diesem Falle wird die Differenz allerdings nicht mehr ausgehend von der ursprünglichen Kennlinie 24, sondern genaugenommen ausgehend von der Kennlinie 19 eines defekten Sensors als Meßwert ersichtlich.

Aus all diesen Signaldifferenzen lassen sich nun die erforderlichen Prognosen erstellen, und insbesondere die Ausfallwahrscheinlichkeit von induktiven Näherungssensoren zur Überwachung der Position von beweglichen Weichen- oder Schienenteilen quantifizieren.

## Patentansprüche

1. Einrichtung zur Überwachung und Prognose der Ausfallswahrscheinlichkeit von induktiven Näherungssensoren (1) zur Überwachung der Position von beweglichen Weichen- oder Schienenteilen, bei welcher der Näherungssensor (1) wenigstens eine von einem Oszillator (7) gespeiste Spule (5) aufweist und der durch veränderliche Bedämpfung fließende Sensorstrom gemessen und einer Auswerteschaltung zugeführt wird, **dadurch gekennzeichnet, dass** Kennlinien (18,22) des Sensors (1) für den Verlauf des Sensorstroms in Abhängigkeit vom Abstand der beweglichen Weichenoder Schienenteile, d.h. der mechanischen Bedämpfung, in elektrisch nicht zusätzlich bedämpftem Zustand (18) und in elektrisch zusätzlich bedämpftem Zustand (22) gespeichert sind und dass wenigtens ein Meßwertpaar bestehend aus dem zyklisch abgetasteten, einem mechanischen Bedämpfungszustand entsprechenden, sowie dem jeweils dem zusätzlich elektrisch bedämpften Zustand entsprechenden Sensorstrom (24) ermittelt wird und die Meßwertpaare einer Vergleichs- und Auswerteschaltung zugeführt sind, in welcher die sich aufgrund der Kennlinien ergebenden Differenzen mit den gemessenen Differenzen der Meßwertpaare verglichen werden.

2. Einrichtung nach Anspruch 1, **dadurch gekennzeichnet, daß** die Signale der Meßwertpaare für wenigstens zwei unterschiedliche mechanische Bedämpfungen der Auswerteschaltung zugeführt sind.

3. Einrichtung nach Anspruch 1 oder 2, **dadurch gekennzeichnet, daß** die elektrische Bedämpfung durch eine Anhebung der Versorgungsspannung erfolgt.

4. Einrichtung nach Anspruch 1, 2 oder 3, **dadurch gekennzeichnet, daß** die elektrische Bedämpfung über einen Abgriff (17) der Sensorspule (5) erfolgt.

5. Einrichtung nach einem der Ansprüche 1 bis 4, **dadurch gekennzeichnet, daß** ein die elektrische Bedämpfung über einen Widerstand (15) am Abgriff (17) der Sensorspule (5) steuernder Transistor (14) vorgesehen ist, dessen Basis (13) über eine z-Diode (10) mit der Versorgungsspannung verbunden ist.

6. Einrichtung nach einem der Ansprüche 1 bis 5, **dadurch gekennzeichnet, daß** wenigstens eine Auswertung der Differenz der Meßwertpaare in mechanisch unbedämpfter Lage erfolgt.

## Claims

1. Device for the monitoring and the prognosis of the failure probability of inductive proximity sensors (1) for the monitoring of the position of movable switch rail or rail components, in which the proximity sensor (1) has at least one coil (5) that is supplied by an oscillator (7), and the sensor current flowing by means of variable attenuation is measured, and is fed to an evaluation circuit, **characterized in that** characteristic lines (18, 22) of the sensor (1) are stored in the electric not additionally attenuated condition (18), and in the electric additionally attenuated condition (22) for the course of the sensor currents in dependency of the distance of the movable switch rails, or rail components, i.e., the mechanical attenuation, and that at least one measurement reading pair consisting of the measuring currents (24) corresponding to the mechanical attenuation condition, as well as to the respective additionally electric attenuated condition being cyclically scanned, and that the measurement reading pairs are fed to a comparison and evaluation circuit, in which the differences due to the characteristic lines are compared to the measured differences of the measurement reading pair.

2. Device according to claim 1, **characterized in that** the signals of the measurement reading pairs for at least two different mechanical attenuations are fed to the evaluation circuit.

3. Device according to claims 1 or 2, **characterized in that** the electric attenuation occurs by means of increase of the supply voltage.

4. Device according to claims 1, 2, or 3, **characterized in that** the electric attenuation occurs by means of a tap (17) of the sensor coil (5).

5. Device according to one of the claims 1 to 4, **characterized in that** a transistor (14) controlling the electric attenuation by means of a resistance (15) at the tap (17) of the sensor coil (5) is intended, the base (13) of which is connected to the supply voltage by means of a break-down diode (10).

6. Device according to one of the claims 1 to 5, **characterized in that** at least one evaluation of the difference of the measurement reading pairs occurs in a mechanically non-attenuated condition.

## Revendications

1. Dispositif destiné à surveiller et à pronostiquer la probabilité de panne de détecteurs de proximité à induction (1) pour la surveillance de la position de parties d'aiguillage ou de rail mobiles, dans lequel le détecteur de proximité (1) possède au moins un bobinage (5) alimenté par un oscillateur (7) et dans lequel le courant de détecteur passant par une atténuation modifiable est mesuré et transmis à un circuit d'interprétation, **caractérisé en ce que** des courbes caractéristiques (18, 22) du détecteur (1) concernant l'évolution du courant de détecteur en fonction de la distance des parties d'aiguillage ou de rail mobiles, c'est-à-dire de l'atténuation mécanique, sont enregistrées dans l'état sans atténuation électrique supplémentaire (18) et avec atténuation électrique supplémentaire (22) et **en ce qu'**au moins une paire de valeurs de mesure composée du courant de détecteur (24) détecté de manière cyclique et correspondant à l'état d'atténuation mécanique ainsi qu'à l'état avec atténuation électrique supplémentaire est déterminée et la paire de valeurs de mesure est amenée à un circuit de comparaison et d'interprétation dans lequel les différences établies sur la base des courbes caractéristiques sont comparées aux différences mesurées des paires de valeurs de mesure.

2. Dispositif selon la revendication 1, **caractérisé en ce que** les signaux des paires de valeurs de mesure pour au moins deux atténuations mécaniques différentes sont amenés au circuit d'interprétation.

3. Dispositif selon la revendication 1 ou 2, **caractérisé en ce que** l'atténuation électrique est réalisée par augmentation de la tension d'alimentation.

4. Dispositif selon la revendication 1, 2 ou 3, **caractérisé en ce que** l'atténuation électrique est réalisée par une prise (17) sur le bobinage du détecteur (5).

5. Dispositif selon l'une ou l'ensemble des revendications 1 à 4, **caractérisé en ce qu'**il est prévu un transistor (14) contrôlant l'atténuation électrique par l'intermédiaire de la résistance (15) au niveau de la prise (17) du bobinage du détecteur (5), dont la base (13) est reliée à la tension d'alimentation par l'intermédiaire d'une diode de Zener(10).

6. Dispositif selon l'une ou l'ensemble des revendications 1 à 5, **caractérisé en ce qu'**au moins une interprétation de la différence des valeurs de mesure est effectuée dans l'état sans atténuation mécanique.
